# EUROPEAN PATENT APPLICATION

(11) **EP 4 391 092 A1**
(43) Date of publication of application: **26.06.2024**
(21) Application number: 22872761.6
(22) Date of filing: 12.09.2022
(51) Int. Cl.: H01L 33/00, H01L 33/62, H01S 5/0232

(54) **LIGHT-EMITTING DEVICE, AND METHOD FOR PRODUCING LIGHT-EMITTING DEVICE**

(30) Priority: 24.09.2021 JP 2021155361
(71) Applicant: Stanley Electric Co. Ltd., Tokyo 153-8636 (JP)
(72) Inventor: SHIMODA, Yoichi, Tokyo 153-8636 (JP); KAMBARA, Daizo, Tokyo 153-8636 (JP); SHIGEEDA, Yuji, Tokyo 153-8636 (JP); ICHIKAWA, Koji, Tokyo 153-8636 (JP); ISHIKO, Hiroyuki, Tokyo 153-8636 (JP)
(74) Representative: Pritzlaff, Stefanie Lydia
(86) International application number: PCT/JP2022/034086
(87) International publication number: WO 2023/048007

(57) **Abstract**

The present invention includes: a plurality of flat lead electrodes; a frame body which covers the side portions of the plurality of lead electrodes and a separation portion between the plurality of lead electrodes and has an opening that exposes the plurality of lead electrodes; and a light-emitting element mounted on the plurality of lead electrodes exposed through the opening. The outer side surface of the frame body has recesses extending from the top surface of the frame body to the bottom surface thereof, the lead electrodes partly protruding in the recesses.

## Description

### Technical Field

The present invention relates to a light-emitting device, and more particularly, to a light-emitting device in which a semiconductor light-emitting element such as a light-emitting diode (LED) is mounted on a lead frame, and a method for producing the light-emitting device.

### Background Art

Conventionally, there has been known a light-emitting device formed by providing a resin body on a lead frame by insert molding and then cut with a dicer.

For example, Patent Literature 1 discloses a method for forming a light-emitting device by forming a resin molded body on a lead frame provided with notches and then cutting the resin molded body and the lead frame along the notches.

Further, Patent Literature 2 discloses a surface-mount type light-emitting device having a first resin molded body formed by integrally molding a light-emitting element and first and second leads, and a second resin molded body that includes a fluorescent body that covers the light-emitting element.

### Citation List

### Patent Literatures

Patent Literature 1: Japanese Patent Application Laid-Open No. 2010-62272
Patent Literature 2: Japanese Patent Application Laid-Open No. 2006-156704

### Summary of Invention

### Technical Problem

However, cutting resin and a lead frame that have been integrally molded has been posing problems such as separation between the resin and the lead frame, decrease in die shear strength, and disconnection failure.

The present invention has been made in view of the circumstances described above, and it is an object of the invention to provide a light-emitting device that prevents separation between resin and a lead frame, has a high die shear strength of solder joints, and minimizes possibilities of disconnection failure and the like, and a method for producing the light-emitting device.

### Solution to Problem

A light-emitting device according to a first embodiment of the present invention includes:
a plurality of flat lead electrodes;
a frame body which covers side portions of the plurality of lead electrodes and a separation portion between the plurality of lead electrodes and has an opening that exposes the plurality of lead electrodes; and
a light-emitting element which is mounted on the plurality of lead electrodes exposed through the opening,
wherein an outer side surface of the frame body has a recess extending from a top surface of the frame body to a bottom surface thereof, and
a part of the lead electrodes protrudes in the recess.

A method for producing a light-emitting device according to another embodiment of the present invention includes the steps of:
(a1) forming a stepped portion along outer peripheries of back surfaces of a plurality of lead electrodes included in each unit section according to a plurality of unit sections of a lead frame, and forming a lead connection that interconnects the plurality of lead electrodes of adjacent unit sections;
(a2) performing insert molding of a frame body resin to cover side portions of the plurality of lead electrodes and a separation portion between the plurality of lead electrodes, and forming a molded resin body that has a first opening for mounting an element through which the plurality of lead electrodes are exposed, and a second opening through which the lead connection is exposed;
(a3) punching a part of the lead connection from the second opening to cut leads;
(a4) mounting a light-emitting element on the plurality of lead electrodes exposed through the first opening; and
(a5) performing dicing according to the plurality of unit sections so as to obtain separate individual light-emitting devices.

### Brief Description of Drawings

FIG. 1A is a perspective view schematically illustrating a light-emitting device 10 according to a first embodiment of the present invention.
FIG. 1B is a diagram illustrating the top surface of the light-emitting device 10.
FIG. 1C is a diagram illustrating the back surface of the light-emitting device 10.
FIG. 2A is a top view schematically illustrating the inside of the light-emitting device 10.
FIG. 2B is a top view illustrating a lead 12A and a lead 12B observed from the top surface side.
FIG. 2C is a sectional view taken along line A-A illustrated in FIG. 2A.
FIG. 2D is a sectional view taken along line B-B illustrated in FIG. 2A.
FIG. 2E is a side view illustrating the right side surface of the light-emitting device 10.
FIG. 3 is a top view illustrating the detailed configuration of the lead 12A.
FIG. 4 is a perspective view illustrating an example of the mounting of the light-emitting device 10 onto a circuit board 41.
FIG. 5A is a partial enlarged perspective view illustrating a recess 23 of a resin frame body 22 and a protrusion 12AP of the lead 12A in an enlarged view.
FIG. 5B is a perspective view schematically illustrating the recess 23 when the light-emitting device 10 has been mounted on the circuit board 41.
FIG. 5C is a diagram schematically illustrating the shapes of a recess 23 and a protrusion 12AP of a lead 12Ain another example.
FIG. 6 is a flowchart illustrating a first method for producing the light-emitting device 10.
FIG. 7A is a top view illustrating step S11 of the first production method.
FIG. 7B is a top view illustrating step S12 of the first production method.
FIG. 7C is a top view illustrating step S13 of the first production method.
FIG. 7D is a top view illustrating step S14 of the first production method.
FIG. 7E is a top view illustrating step S15 of the first production method.
FIG. 7F is a top view illustrating step S17 of the first production method.
FIG. 8A is a top view illustrating openings 26 of a molded resin body 22F.
FIG. 8B is a sectional view schematically illustrating a section taken along line P-P in FIG. 8A, and a method for cutting the leads.
FIG. 9A is a top view illustrating the protrusion 12AP of the lead 12A (or a protrusion 12BP of the lead 12B) protruding in the recess 23.
FIG. 9B is a top view illustrating another example of the protrusion 12AP or 12BP protruding in the recess 23.
FIG. 10 is a flowchart illustrating a second method for producing the light-emitting device 10.

### Description of Embodiments

The following will describe preferred embodiments of the present invention. The embodiments may be modified or combined as appropriate. Further, in the following descriptions and the accompanying drawings, substantially the same or equivalent components will be assigned the same reference numerals in the descriptions.

### [First Embodiment]

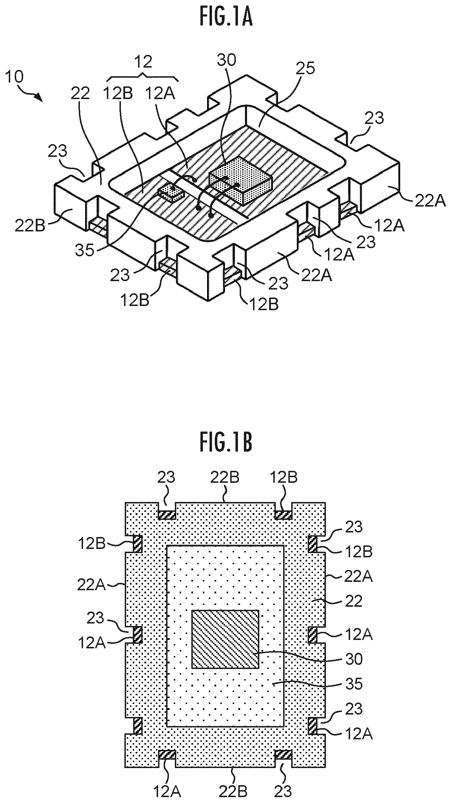

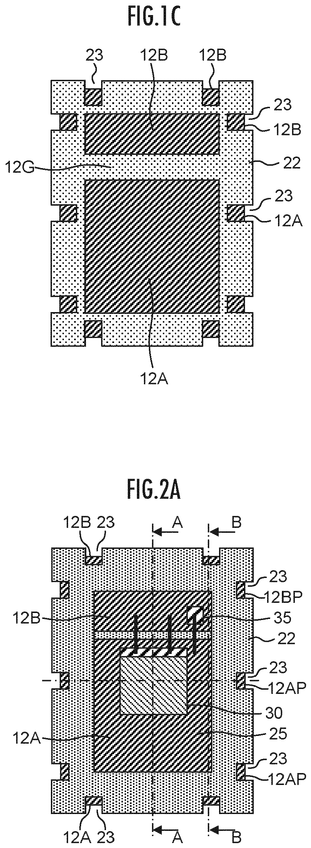

FIG. 1A is a perspective view schematically illustrating a light-emitting device 10 according to a first embodiment of the present invention. The light-emitting device 10 has a plurality of lead electrodes (hereinafter referred to simply as leads), a resin frame body 22, and a light-emitting element 30. FIG. 1B is a diagram illustrating the top surface of the light-emitting device 10 and FIG. 1C is a diagram illustrating the back surface thereof.

The light-emitting device 10 has a flat lead 12A (a first electrode) and a flat lead 12B (a second electrode). The lead 12A and the lead 12B are made of Cu (copper), and the surfaces thereof are plated with Ni/Au (nickel/gold). A lead pair 12 composed of the leads 12A and 12B (hereinafter also referred to as a lead frame 12 of the light-emitting device 10) is formed on substantially the same plane and spaced apart from each other by a separation portion (slit) 12G.

The resin frame body 22 is formed on the lead 12A and the lead 12B, which are thus formed as a resin package. The resin frame body 22 is formed of a silicone resin and/or an epoxy resin, and contains light-reflecting particles such as titanium oxide particles (so-called white resin). Further, a light absorbing material such as carbon black may be contained.

The resin frame body 22 has a rectangular shape, and four outer side surfaces 22A and 22B of the resin frame body 22 are provided with recesses 23 extending from the top surface of the resin frame body 22 to the bottom surface thereof. A part of the lead 12A or the lead 12B protrudes to be exposed in the recess 23 on the bottom surface side of the resin frame body 22.

In the light-emitting device 10 illustrated in FIG. 1, an outer side surface 22A parallel to the arrangement direction of the leads 12A and the leads 12B (hereinafter also referred to as the longitudinal outer side surface 22A) is provided with a total of three recesses 23, two corresponding to the number of the leads 12A and one corresponding to the number of the lead 12B. The leads 12A and the lead 12B partly protrude in the recesses 23.

Further, the outer side surface 22B perpendicular to the arrangement direction (hereinafter also referred to as the lateral outer side surface 22B) is provided with two recesses 23 in which the lead 12A or the lead 12B partly protrudes.

The resin frame body 22 has an opening 25 (first opening), which is an inner area of the frame body, and the surfaces of the lead 12A and the lead 12B are partly exposed through the opening 25. The light-emitting element 30 is mounted in the opening 25.

The light-emitting element 30 is an LED (Light-Emitting Diode) in the present embodiment, but may be any other light-emitting element such as a laser diode.

More specifically, for example, the lead 12A is an anode electrode, the lead 12B is a cathode electrode, a p-electrode of the light-emitting element 30 is connected to and placed on the lead 12A, and an n-electrode of the light-emitting element 30 is connected to the lead 12B by a bonding wire.

Further, the light-emitting element 30 has a fluorescent body provided on the LED chip. Alternatively, the light-emitting element 30 may have a light-transmitting body, an optical member, or the like. The fluorescent body is not particularly limited, but various fluorescent bodies such as YAG (yttrium aluminum garnet), LuAG (lutetium aluminum garnet), GdAG (gadolinium aluminum garnet), α/β-sialon, SCASN, CASN, KFS, or the like can be used as appropriate.

Further, a protection element 35, which is a zener diode, is provided on the lead 12A and the lead 12B exposed through the opening 25. As the protection element 35, a varistor or the like can be used. Further, a passive element such as a capacitor, a resistor or a light receiving element may be provided.

In the opening 25 of the resin frame body 22, the space around the light-emitting element 30 is filled with a coating member 55, which is a sealing resin or a coating resin. FIG. 1A does not illustrate the coating member 55 for the purpose of showing the internal structure. Further, the surface of the light-emitting element 30 is exposed from the coating member 55. In addition, as the coating member 55, a light-reflecting resin containing titanium oxide particles or the like in a silicone resin can be used, but the coating member 55 is not limited thereto.

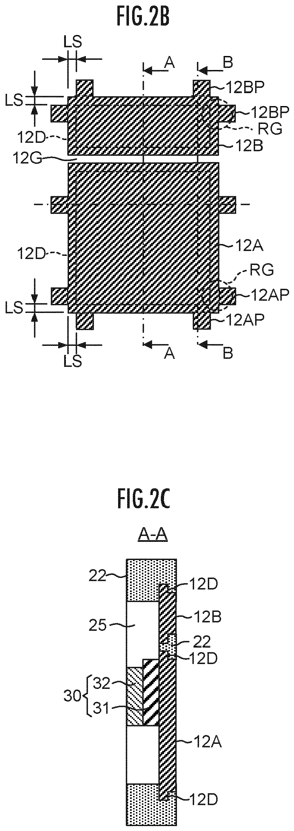

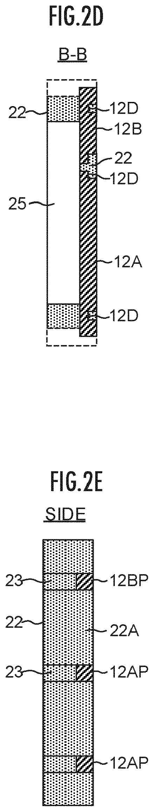

FIG. 2A is a top view schematically illustrating the inside of the light-emitting device 10. The coating member 55 is not illustrated. FIG. 2B is a top view illustrating the lead 12A and the lead 12B observed from the top surface side. FIG. 2C and FIG. 2D are sectional views taken along line A-A and line B-B, respectively, illustrated in FIG. 2A. FIG. 2E is a side view illustrating the right side surface of the light-emitting device 10.

As illustrated in the top view of FIG. 2A, the resin frame body 22 has a rectangular shape as viewed from above, and has the opening 25 shaped like a rectangular pillar, which is the inner area of the frame body. The inside of the opening 25 is filled with the coating member 55 (not illustrated). The shape of the opening 25 is not limited to the rectangular pillar shape, and may alternatively be a different shape such as a columnar shape.

The light-emitting element 30 is bonded on the lead 12A, and the protection element 35 is bonded and mounted on the lead 12B. One electrode of the light-emitting element 30 and one electrode of the protection element 35 are connected to the lead 12B and the lead 12A, respectively, by bonding wires.

As illustrated in FIG. 2B, the leads 12A and 12B are separated by the slit 12G. Further, the leads 12A and 12B have protrusions at positions corresponding to the recesses 23 of the resin frame body 22. In the following description, these protrusions in particular will be referred to as protrusions 12AP and 12BP of the leads 12A and 12B.

Further, the leads 12A and 12B have, on the back surfaces thereof, rectangular annular stepped portions 12D formed along the outer peripheries of the leads 12A and 12B. Each of the stepped portions 12D has a width LS and is formed by half etching to a depth of, for example, approximately 50%, of the thickness of the leads 12A and 12B.

As illustrated in FIG. 2B, FIG. 2C, and FIG. 2D, the stepped portions 12D are formed as grooves in areas RG where the protrusions 12AP and 12BP of the leads 12A and 12B are formed, and are formed as steps in the remaining area, i.e., the edge portions of the main bodies of the leads 12A and 12B.

Further, the stepped portions 12D are described using an example in which the stepped portions 12D are formed over the entire outer peripheries of the leads 12A and 12B, but the stepped portions 12D are not limited thereto. Alternatively, the stepped portions 12D may be formed on a part of the outer peripheries of the leads 12A and 12B, or may be formed, for example, along the outer peripheries of the leads 12A and 12B excluding the corner portions thereof. Further alternatively, the stepped portions 12D may be formed along the outer peripheries excluding the areas RG where the protrusions 12AP and 12BP are formed.

As illustrated in FIG. 2C to 2E, the resin frame body 22 is insert-molded in such a manner as to cover the sides around the leads 12A and 12B. Further, the resin frame body 22 is filled in the slit 12G between the leads 12A and 12B. Further, the resin frame body 22 is also filled in the stepped portions 12D of the leads 12A and 12B. Although the resin frame body 22 is preferably filled to such an extent that the stepped portions 12D are completely buried, the stepped portions 12D may alternatively be buried to a certain depth or more.

Consequently, as illustrated in FIG. 2C, the edge portions of the leads 12A and 12B are covered by the resin of the resin frame body 22, thus preventing the resin frame body 22 from peeling off.

As illustrated in FIG. 2C, the light-emitting element 30 has an LED chip (die) 31, which is a semiconductor element, and a fluorescent body 32 placed on the LED chip 31. In addition, as illustrated in FIG. 1B, the coating resin is filled in the opening 25 of the resin frame body 22, and the coating member 55 is formed in such a manner as to coat the surrounding area of the light-emitting element 30.

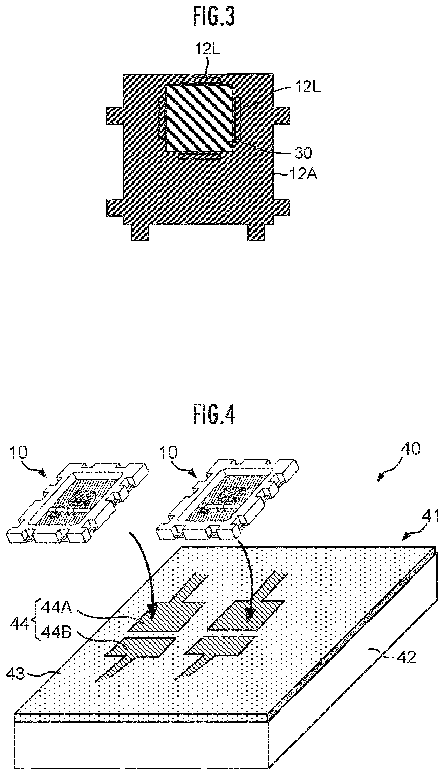

FIG. 3 is a top view illustrating the detailed configuration of the lead 12A. The lead 12A is provided with alignment grooves 12L extending around the mounting area of the light-emitting element 30 according to the outer surface of the light-emitting element 30. The alignment grooves 12L are formed by, for example, etching the surface of the lead 12A.

Since the alignment grooves 12L are formed on the lead 12A, the LED chip 31 is aligned when the LED chip 31 is fusion-joined using a bonding material such as AuSn (self-alignment).

FIG. 4 is a perspective view illustrating an example of the mounting of the light-emitting device 10 onto a circuit board 41. Two light-emitting devices 10 are mounted on the circuit board 41 to form a light-emitting system 40.

The circuit board 41 has a substrate layer 42 having a metal core made of Cu (copper) or the like, an insulating film 43 disposed on the substrate layer 42, and a wiring circuit 44 formed on the insulating film 43. The insulating film 43 is made of ceramic such as alumina, or resin such as polyimide or heat-resistant epoxy. The wiring circuit 44 is formed of a wiring layer in which Ni (nickel)/Au is formed on, for example, Cu.

Alternatively, for the circuit board 41, a board with metal wiring formed on the surface of an insulating substrate made of ceramics or the like can be suitably used. As the insulating substrate, a substrate made of a material with high thermal conductivity, such as Al₂O₃, AlN, or SiN, is suitably used.

The light-emitting device 10 is joined onto the wiring circuit 44 by using a bonding material such as solder. More specifically, the lead 12A (the anode electrode) and the lead 12B (the cathode electrode) of the light-emitting device 10 are connected to an anode wire 44A and a cathode wire 44B, respectively, of the wiring circuit 44.

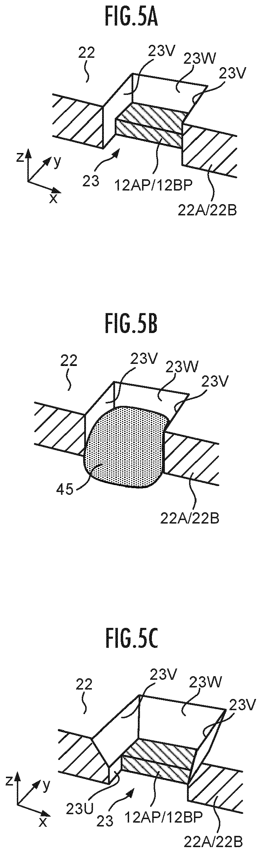

FIG. 5A is a partial enlarged perspective view illustrating the recess 23 of the resin frame body 22 and the protrusion 12AP of the lead 12A in an enlarged view. The lead 12A will be described below, and the same applies to the protrusion 12BP of the lead 12B. The same also applies to the recesses 23 in the longitudinal outer side surface 22A and the lateral outer side surface 22B of the resin frame body 22.

As illustrated in FIG. 5A, the protrusion 12AP of the lead 12A is exposed in the recess 23 of the resin frame body 22. More specifically, the recess 23 has inner wall surfaces 23V and 23W, and the protrusion 12AP of the lead 12A protrude from the inner wall surface 23W and is exposed to the outside. Further, the protrusion 12AP is placed at a position recessed inward relative to the outer side surface 22A of the resin frame body 22. This structure makes it possible to easily check lighting by applying a probe needle from above before mounting the light-emitting device 10 onto the circuit board 41.

Further, when the light-emitting device 10 is mounted on the circuit board 41 with solder, solder 45 creeps up onto the top surface of the protrusion 12AP of the lead 12A protruding in the recess 23, as illustrated in FIG. 5B, thus improving both the die shear strength and the solder joint strength.

FIG. 5C is a diagram schematically illustrating the shapes of a recess 23 and a protrusion 12AP of a lead 12A in another example. In the case illustrated in FIG. 5A, the inner wall surfaces 23V and 23W of the recess 23 are substantially vertical surfaces with respect to the lead 12A, but the inner wall surfaces 23V and 23W may be tapered surfaces which incline from the vertical surfaces such that the opening thereof becomes larger as the distance from the lead 12A increases, as illustrated in FIG. 5C. Alternatively, an inner wall surface 23U in contact with the side surface of the protrusion 12AP of the lead 12A may be a tapered surface such that the opening becomes larger toward the back surface of the resin frame body 22.

### [Production method]

The following will describe in detail a first and a second methods for producing the light-emitting device 10 with reference to the accompanying flowcharts and drawings.

### [A] First production method

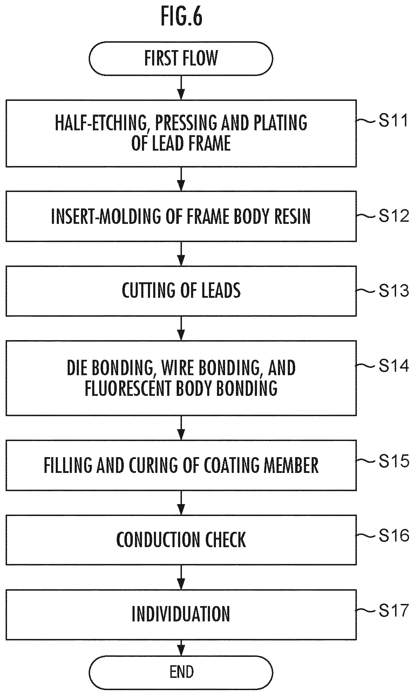

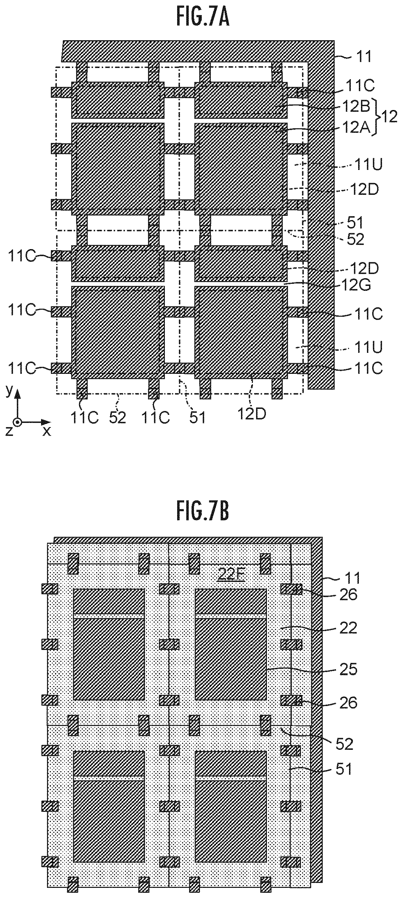

FIG. 6 is a flowchart illustrating the first method for producing the light-emitting device 10. Further, FIG. 7A to FIG. 7F are top views illustrating the individual steps. Referring to FIG. 6 and FIG. 7A to FIG. 7F, the method for producing the light-emitting device 10 will be described below.

### <Step S11> : Half-etching, pressing and plating a lead frame

A lead frame 11 has a plurality of unit sections 11U arranged in a matrix. More specifically, the lead frame 11 is divided into the plurality of unit sections 11U by vertical dicing lines 51 and horizontal dicing lines 52 arranged at equal intervals in a horizontal direction (x-direction) and a vertical direction (y-direction). Each of the unit sections 11U corresponds to the lead frame 12 of one light-emitting device 10.

First, as illustrated in FIG. 7A, the stepped portions 12D are formed on the back surface of the lead frame 11 by performing half-etching to predetermined width and depth. Then, punching (pressing) is performed to form the lead connections 11c and the slits 12G. Thus, the lead pair 12 composed of the leads 12A and 12B, and the lead connections 11C that interconnect the lead pairs 12 of adjacent unit sections 11U are formed.

Subsequently, the front and back surfaces of the lead frame 11 are treated by, for example, Ni/Au plating.

### <Step S12> : Insert molding of a frame body resin

As illustrated in FIG. 7B, insert molding of the frame body resin is performed to form a molded resin body 22F. More specifically, the lead frame 11 is sandwiched between an upper mold and a lower mold, and a thermosetting resin is injected to form the molded resin body 22F.

In FIG. 7B to FIG. 7F, for the purpose of clarity of illustrations and ease of understanding, the vertical dicing lines 51, the horizontal dicing lines 52, and portions corresponding to punched holes (punched portions 26H) to be described later are indicated by solid lines.

The molded resin body 22F is provided with the opening 25, which is the inner area of the resin frame body 22, corresponding to each of the unit sections 11U. In addition, the molded resin body 22F is provided with openings 26 (second openings) through which the lead connections 11C are exposed.

The openings 26 through which the lead connections 11C are exposed are cut by dicing, which will be described later, to form the above-described recesses 23. The opening 26 is formed by holding down the stay portion (lead portion) of the lead frame 11 by an upper mold provided with a convex portion. Consequently, the flapping of the frame when inserting the resin can be suppressed, thus making it possible to prevent a failure in which the resin wraps around to the back surface of a cut end portion.

### <Step S13> : Cutting the leads

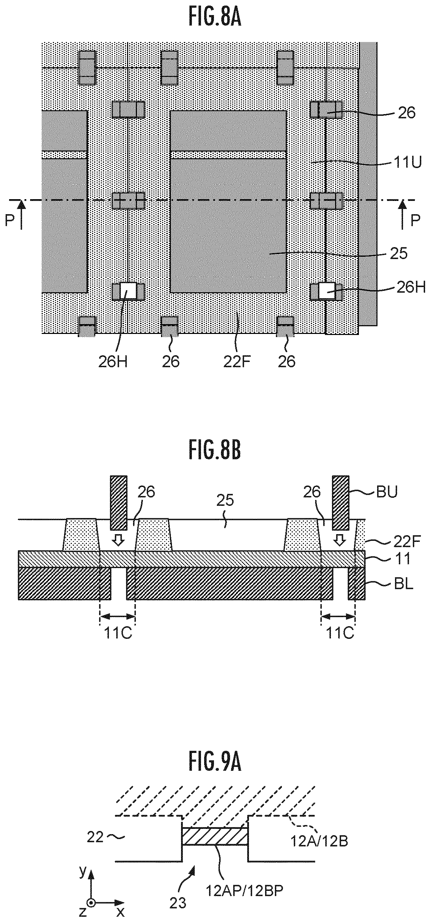

Subsequently, the lead connections 11C are punched from the openings 26 to cut the leads. FIG. 8A is a top view illustrating the openings 26 of the molded resin body 22F, and FIG. 8B is a sectional view schematically illustrating the section taken along line P-P in FIG. 8A and the method for cutting the leads.

FIG. 8A illustrates the openings 26 provided around the unit section 11U of the lead frame 11, and punched portions (punched holes) 26H, which are portions obtained by punching out a part of the lead connections 11C.

As illustrated in FIG. 8B, the lead frame 11 on which the molded resin body 22F has been formed is placed on a lower blade BL. A part of the central portion of each of the lead connections 11C is punched out from above by an upper blade BU to form a punched portion 26H, and the lead connection 11C is cut.

A portion of the top surface of the lead frame 11 that corresponds to the punched portion 26H can be half-etched for easier punching.

FIG. 9A is a top view illustrating the protrusion 12AP of the lead 12A or the protrusion 12BP of the lead 12B formed by punching a part of the central portion of the lead connection 11C. A part of the lead connection 11C that has remained after punching protrudes to the space in the recess 23 of the resin frame body 22.

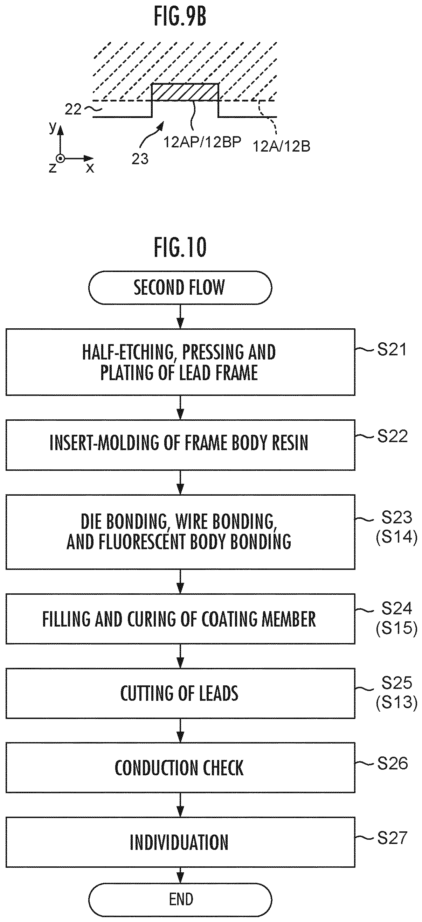

As illustrated in FIG. 9B, the entire lead connection 11C may be punched out, and the lead 12 may be formed such that a part of the lead 12A, which is the same side surface with the side surface of the lead 12A (or the lead 12B), protrudes in the recess 23.

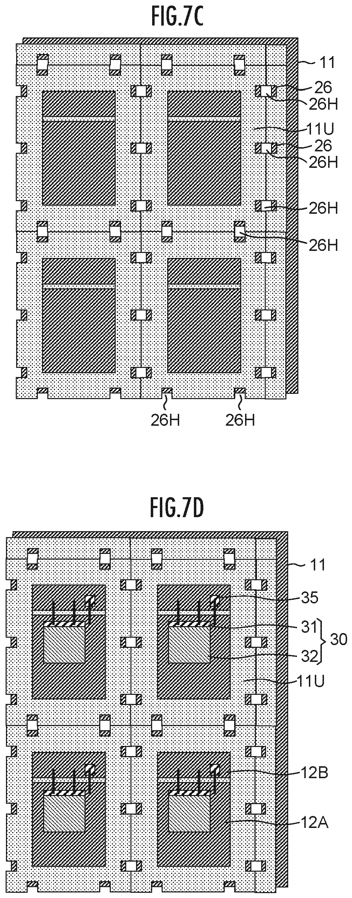

As illustrated in FIG. 7C, all the lead connections 11C connecting the leads between adjacent unit sections 11U are cut thereby to separate the lead frames 12 of each of the light-emitting devices 10.

### <Step S14> : Die bonding, wire bonding, and fluorescent body bonding

Subsequently, as illustrated in FIG. 7D, the LED chip 31 is bonded onto the lead 12A by using an AuSn bonding material. Further, the protection element 35 is bonded to the lead 12B. The electrodes formed on the top surfaces of the LED chip 31 and the protection element 35 are connected to the lead 12B and the lead 12A, respectively, by wire bonding.

Subsequently, the fluorescent body 32 is bonded onto the LED chip 31 by using an adhesive agent to form the light-emitting element 30.

### <Step S15> : Filling and curing of a coating member

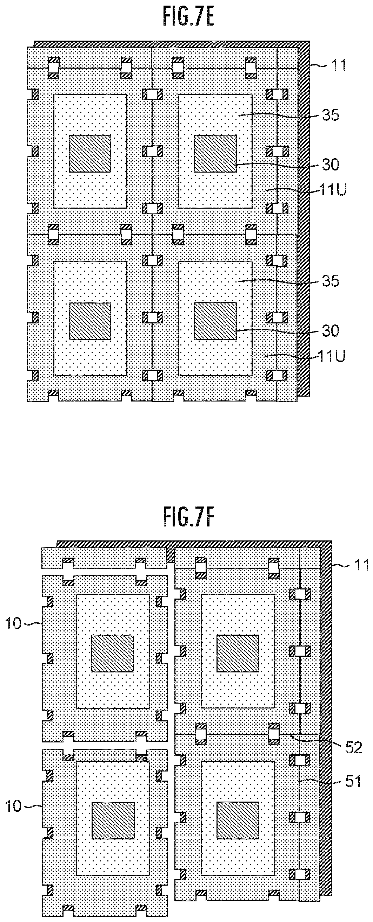

Subsequently, as illustrated in FIG. 7E, the openings 25 of the resin frame body 22 are coated with a light-reflecting resin containing titanium oxide particles such that the surfaces of the light-emitting elements 30 are exposed, and then the light-reflecting resin is cured to form the coating members 55.

### <Step S16> : Checking for conduction

At this stage, the electrical characteristics of each of the light-emitting devices 10 are tested, such as checking for conduction. More specifically, the lead connections 11C are cut by lead cutting (step S13), so that the lead frames (the lead pairs 12) of adjacent light-emitting devices 10 are electrically cut. This makes it possible to check the light-emitting devices 10 for conduction before being separated (individuated) into individual light-emitting devices 10 by dicing or the like.

### <Step S17> : Individuation

Lastly, as illustrated in FIG. 7F, dicing is performed along the vertical dicing lines 51 and the horizontal dicing lines 52, i.e., the molded resin body 22F is cut to separate the light-emitting devices 10 into individual pieces. Through the steps described above, the production of the light-emitting device 10 is completed.

### [B] Second production method

The following will describe the second method for producing the light-emitting device 10 with reference to the flowchart of FIG. 10. The second production method includes the steps described below. The second production method differs from the above-described first production method in the order of steps. In the following, "step S21 (=step S11)" and the like mean that step S21 is a step with the same contents as step S11 described above, and a specific explanation will be omitted.

The second production method includes the following steps.
< Step S21 (= step S11) > : Half-etching, pressing and plating a lead frame
< Step S22 (= step S12) > : Insert-molding a frame body resin
< Step S23 (= step S14) > : Die bonding, wire bonding, fluorescent body bonding
< Step S24 (= step S15) > : Filling and curing of a coating member
< Step S25 (= step S13) > : Lead cutting
< Step S26 (= step S16) > : Checking for conduction
< Step S27 (= step S17) > : Individuation

Through the steps described above, the production of the light-emitting device 10 is completed.

### [C] Advantages of the first and the second production methods

### (C-1) Advantages common to the first and the second production methods

According to the first and the second production methods, the lead connections 11C between the light-emitting devices 10 are cut so as to separate the leads of the light-emitting devices 10 before the light-emitting devices 10 are separated (individuated) into individual pieces by dicing or the like.

Consequently, each of the light-emitting devices 10 can be independently checked for conduction before separating the light-emitting devices 10 by dicing or the like.

Further, in the step of individuation by dicing (step S17 or S27), the molded resin body 22F is cut and the leads are not cut, so that the deflection or the like of the lead frame is less likely to occur, thus preventing disconnection failure.

Further, the lead cutting (step S13 or S25) is performed before the individuation step (step S17 or S27). In other words, the cutting of the metal lead frame and the cutting of the resin frame body are separately performed, thus making it possible to prevent the separation between the resin frame body 22 and the leads 12A and 12B. In addition, cutting tools can be optimized for metals and for resins, so that cut surfaces can be neatly finished.

### (C-2) Advantages of the first production method

The lead cutting is performed after insert-molding the frame body resin, so that the deflection of a molded sheet can be prevented. Further, in the die bonding for bonding the LED chip 31, the deformation of the molded sheet can be prevented.

As described in detail above, the present invention can provide a light-emitting device that prevents the separation between a frame body and a lead frame, has high die shear strength of solder joints, and minimizes possibilities of the occurrence of disconnection failure or the like, and a method for producing the light-emitting device.

### Description of Reference Numerals

10: light-emitting device
11: lead frame
11C: lead connection
11U: unit section
12A, 12B: lead
12AP, 12BP: protrusion
12D: stepped portion
12G: separation portion (slit)
12L: alignment groove
22: resin frame body
22A, 22B: outer side surface
23: recess
25: opening
26: opening
26H: punched portion
30: light-emitting element
31: LED chip
51, 52: dicing line

## Claims

1. A light-emitting device comprising:
a plurality of flat lead electrodes;
a frame body which covers side portions of the plurality of lead electrodes and a separation portion between the plurality of lead electrodes, and has an opening that exposes the plurality of lead electrodes; and
a light-emitting element which is mounted on the plurality of lead electrodes exposed through the opening,
wherein an outer side surface of the frame body has a recess extending from a top surface of the frame body to a bottom surface thereof, and
a part of the lead electrode protrudes in the recess.

2. The light-emitting device according to claim 1, wherein the part of the lead electrode protruding in the recess is disposed on an inner side relative to the outer side surface of the frame body.

3. The light-emitting device according to claim 1 or 2, wherein the plurality of lead electrodes have stepped portions formed along outer peripheries of back surfaces of the plurality of lead electrodes.

4. The light-emitting device according to any one of claims 1 to 3, including a coating member filled in the opening so as to cover an area around the light-emitting element.

5. The light-emitting device according to any one of claims 1 to 4, wherein the light-emitting element has a light-emitting diode and an optical member placed on the light-emitting diode.

6. The light-emitting device according to any one of claims 1 to 5, wherein a groove along an outer side surface of the light-emitting element is provided around a portion of the lead electrode where the light-emitting element is placed.

7. A method for producing a light-emitting device, comprising the steps of:
(a1) forming a stepped portion along outer peripheries of back surfaces of a plurality of lead electrodes included in each unit section according to a plurality of unit sections of a lead frame, and forming a lead connection that interconnects the plurality of lead electrodes of adj acent unit sections;
(a2) performing insert molding of a frame body resin to cover side portions of the plurality of lead electrodes and a separation portion between the plurality of lead electrodes, and forming a molded resin body that has a first opening for mounting an element through which the plurality of lead electrodes are exposed, and a second opening through which the lead connection is exposed;
(a3) punching a part of the lead connection from the second opening to cut a lead;
(a4) mounting a light-emitting element on the plurality of lead electrodes exposed through the first opening; and
(a5) performing dicing according to the plurality of unit sections so as to obtain separate individual light-emitting devices.

8. The method for producing a light-emitting device according to claim 7, including a step of performing electrical testing on the light-emitting element between the steps (a4) and (a5).

## Amended claims

### Amended claims under Art. 19.1 PCT

1. (Amended) A light-emitting device comprising:
a plurality of flat lead electrodes;
a frame body which covers side portions of the plurality of lead electrodes and a separation portion between the plurality of lead electrodes, and has an opening that exposes the plurality of lead electrodes; and
a light-emitting element which is mounted on the plurality of lead electrodes exposed through the opening,
wherein an outer side surface of the frame body has a recess extending from a top surface of the frame body to a bottom surface thereof,
a protrusion which is a part of the lead electrode protrudes in the recess, and
a back surface of the plurality of lead electrodes and a back surface of the protrusion are the same surface.

2. The light-emitting device according to claim 1, wherein the part of the lead electrode protruding in the recess is disposed on an inner side relative to the outer side surface of the frame body.

3. The light-emitting device according to claim 1 or 2, wherein the plurality of lead electrodes have stepped portions formed along outer peripheries of back surfaces of the plurality of lead electrodes.

4. The light-emitting device according to any one of claims 1 to 3, including a coating member filled in the opening so as to cover an area around the light-emitting element.

5. The light-emitting device according to any one of claims 1 to 4, wherein the light-emitting element has a light-emitting diode and an optical member placed on the light-emitting diode.

6. The light-emitting device according to any one of claims 1 to 5, wherein a groove along an outer side surface of the light-emitting element is provided around a portion of the lead electrode where the light-emitting element is placed.

7. A method for producing a light-emitting device, comprising the steps of:
(a1) forming a stepped portion along outer peripheries of back surfaces of a plurality of lead electrodes included in each unit section according to a plurality of unit sections of a lead frame, and forming a lead connection that interconnects the plurality of lead electrodes of adjacent unit sections;
(a2) performing insert molding of a frame body resin to cover side portions of the plurality of lead electrodes and a separation portion between the plurality of lead electrodes, and forming a molded resin body that has a first opening for mounting an element through which the plurality of lead electrodes are exposed, and a second opening through which the lead connection is exposed;
(a3) punching a part of the lead connection from the second opening to cut a lead;
(a4) mounting a light-emitting element on the plurality of lead electrodes exposed through the first opening; and
(a5) performing dicing according to the plurality of unit sections so as to obtain separate individual light-emitting devices.

8. The method for producing a light-emitting device according to claim 7, including a step of performing electrical testing on the light-emitting element between the steps (a4) and (a5).

Statement under Art. 19.1 PCT
The amended claim 1 has changed the description "a part of the lead electrode protrudes in the recess" in claim 1 as filed to "a protrusion which is a part of the lead electrode protrudes in the recess, and a back surface of the plurality of lead electrodes and a back surface of the protrusion are the same surface."

This amendment is based on the matters described in paragraphs [0012], [0027], and [0034] of the specification and FIG. 1C, FIG. 2B, FIG. 2D, and FIG. 2E as originally filed.
